# EUROPEAN PATENT APPLICATION

(11) **EP 4 658 006 A1**
(43) Date of publication of application: **03.12.2025**
(21) Application number: 24209812.7
(22) Date of filing: 30.10.2024
(51) Int. Cl.: H05K 7/20

(54) **ELECTRONIC DEVICE AND ELECTRICAL POWER SYSTEM**

(30) Priority: 28.05.2024 CN 202421191042 U
(71) Applicant: Sungrow (Shanghai) Co., Ltd., Shanghai 201203 (CN)
(72) Inventor: LI, Feng, Shanghai, 201203 (CN); YU, Haiyang, Shanghai, 201203 (CN)
(74) Representative: Epping - Hermann - Fischer

(57) **Abstract**

An electronic device and an electrical power system are provided, which relate to the technical field of electrical technology. The electronic device includes a housing structure, a predetermined structure, and at least one insertion connection structure. The housing structure is provided with a through hole, and the predetermined structure is correspondingly arranged at the through hole and is exposed outside the housing structure. The predetermined structure is attached to a predetermined side of the housing structure along a depth direction of the through hole to form an attaching surface surrounding the through hole, and the at least one insertion connection structure is provided between the predetermined structure and the housing structure at the attaching surface. The at least one insertion connection structure includes a groove portion and an insertion portion that are respectively provided on the predetermined structure and the housing structure, the groove portion is connected to the insertion portion by insertion, and the groove portion surrounds the through hole. The sealing between the housing structure and the predetermined structure of the electronic device can be realized without a sealing ring, and both the heat dissipation requirement and the sealing reliability requirement of the electronic device can be satisfied.

## Description

### FIELD

The present application relates to the technical field of electrical technology, and in particular to an electronic device and an electrical power system.

### BACKGROUND

At present, in some electronic devices, such as an inverter, some structures of an electronic device are generally arranged outside a housing structure of the electronic device for a good heat dissipation performance. For example, an inductor assembly that generates a huge amount of heat or a radiator assembly for heat dissipation is arranged outside the housing structure. These external structures usually pass through a through hole in the housing structure and are connected to a component inside the housing structure, thereby ensuring the heat dissipation performance of the entire device.

These external structures and the housing structure are not tightly connected at the through hole due to reasons such as manufacturing and mounting errors, which leads to a risk of leakage, and therefore the sealing requirement of the electronic device is difficult to meet.

### SUMMARY

An object of the present application is to solve the problem of how to satisfy both the heat dissipation requirement and the sealing requirement of an electronic device in the conventional technology.

To solve at least one aspect of the above problem at least to some extent, in a first aspect, an electronic device is provided according to the present application, including a housing structure, a predetermined structure, and at least one insertion connection structure. The housing structure is provided with a through hole, and the predetermined structure is correspondingly arranged at the through hole and is exposed outside the housing structure. The predetermined structure is attached to a predetermined side of the housing structure along a depth direction of the through hole to form an attaching surface surrounding the through hole, and the at least one insertion connection structure is provided between the predetermined structure and the housing structure at the attaching surface. The at least one insertion connection structure includes a groove portion and an insertion portion that are provided on the predetermined structure and the housing structure, the groove portion is connected to the insertion portion by insertion, and the groove portion surrounds the through hole.

In an embodiment, the groove portion of the at least one insertion connection structure is spaced apart from an edge of the through hole in a direction perpendicular to the depth direction of the through hole.

In an embodiment, the number of the insertion connection structures is more than one, and the insertion connection structures are distributed in the direction perpendicular to the depth direction of the through hole.

In an embodiment, at least two groove portions of different insertion connection structures are respectively arranged on the predetermined structure and the housing structure.

In an embodiment, the electronic device further includes a circuit board unit, the circuit board unit is arranged in a mounting cavity of the housing structure, and the predetermined structure passes through the through hole and is connected to the circuit board unit.

In an embodiment, at least one predetermined structure includes a radiator assembly, and/or, at least one predetermined structure includes a heat generating assembly.

In an embodiment, when the predetermined structure is attached to the predetermined side of the housing structure along the depth direction of the through hole, a shape of a cross section of a predetermined segment of the predetermined structure passing through the through hole is the same as a shape of a cross section of the through hole.

In an embodiment, the predetermined segment is provided with a foolproof portion, and the foolproof portion makes the shape of the cross section of the predetermined segment be non-centrosymmetric.

In an embodiment, the housing structure is provided with a filling port and an air discharging port; in a case that the filling port is located in an area corresponding to the attaching surface, the predetermined structure is provided with a first avoidance opening corresponding to the filling port; and in a case that the air discharging port is located in the area corresponding to the attaching surface, the predetermined structure is provided with a second avoidance opening corresponding to the air discharging port; and/or
the predetermined structure and the housing structure are connected to each other by at least one of a snap-fit connection and a connection by a fastener; and/or
the electronic device is an inverter.

In a second aspect, an electrical power system is provided according to the present application, including the electronic device described above.

Compared with the conventional technology, in the electronic device and the electrical power system according to the present application, the housing structure is provided with the through hole, and the predetermined structure is correspondingly arranged at the through hole and is exposed outside the housing structure. The predetermined structure can be connected to an internal component in the mounting cavity of the housing structure through the through hole to satisfy the connection requirement, and a part of the predetermined structure exposed outside the housing structure can exchange heat with an external environment to satisfy the heat dissipation requirement. Moreover, the predetermined structure is attached to the predetermined side of the housing structure along the depth direction of the through hole to form the attaching surface surrounding the through hole, and the insertion connection structure is provided between the predetermined structure and the housing structure at the attaching surface. The insertion connection structure includes the groove portion and the insertion portion that are provided on the predetermined structure and the housing structure. The groove portion is connected to the insertion portion by insertion, and the groove portion surrounds the through hole. In this way, when the predetermined structure is being connected to the housing structure, the predetermined structure and the housing structure are connected to each other by the insertion between the groove portion and the insertion portion, and the predetermined structure and the housing structure can form a relatively complete sealing surface at the attaching surface in the circumferential direction of the through hole, where the sealing surface includes a part formed at the attaching surface, and a part having an included angle with respect to the attaching surface. Therefore, the sealing reliability of the connection between the predetermined structure and the housing structure can be ensured, and a leaking path of leakage from the mounting cavity of the housing structure through the through hole can be complicated, thereby reducing the possibility of the leakage. In particular, the possibility of leakage of a sealant through the through hole and the attaching surface between the predetermined structure and the housing structure can be reduced when pouring sealant into the mounting cavity of the housing structure, which ensures that most of the sealant filled into the mounting cavity can be used for sealing, such as for wrapping the circuit board unit in the mounting cavity, and a subsequent sealant removing operation due to leakage of the sealant can be avoided. In summary, according to the present application, the sealing between the housing structure and the predetermined structure of the electronic device can be realized without a sealing ring, and both the heat dissipation requirement and the sealing reliability requirement of the electronic device can be satisfied, thereby ensuring the operation performance and the production efficiency of the electronic device.

### BRIEF DESCRIPTION OF THE DRAWINGS

FIG. 1 is a schematic view showing the structure of an electronic device according to a first embodiment of the present application;
FIG. 2 is a sectional view taken along a line A-A in FIG. 1;
FIG. 3 is a schematic view showing a state in which a predetermined structure and a housing structure in FIG. 1 are separated from each other;
FIG. 4 is a schematic view showing the structure of the electronic device shown in FIG. 1 where the predetermined structure is flipped to the right and is opened; and
FIG. 5 is a schematic view showing the structure of an electronic device according to a second embodiment of the present application.

**Reference numerals:**

| | | | |
|---|---|---|---|
| 1 | housing structure, | 11 | first housing, |
| 12 | second housing, | 13 | through hole, |
| 14 | predetermined plate, | 15 | mounting cavity, |
| 2 | predetermined structure, | 2A | radiator assembly, |
| 2B | heat generating assembly, | 21 | predetermined segment, |
| 211 | foolproof portion, | 3 | insertion connection structure, |
| 31 | groove portion, | 32 | insertion portion, |
| 3A | first insertion connection structure, | | |
| 31A | first groove portion, | 32A | first insertion portion, |
| 3B | second insertion connection structure, | | |
| 31B | second groove portion, | 32B | second insertion portion, |
| 301 | first annular protrusion, | 302 | first annular groove, |
| 4 | filling port, | 5 | air discharging port, |
| 6 | first avoidance opening, | 7 | second avoidance opening, |
| 8 | first connecting hole, | 9 | second connecting hole, |
| S | attaching surface. | | |

### DETAILED DESCRIPTION OF THE EMBODIMENTS

Specific embodiments of the present application are described in detail below in conjunction with the accompany drawings, so that objects, features and advantages of the present application can be more obvious and understandable.

In the description of the present application, it should be noted that, unless otherwise clearly specified and limited, the terms "mount", "connected with", "connected to" should be understood broadly. For example, the connection may be in a fixed manner, a detachable manner, or an integral manner, and the connection may be a direct connection, or may be an indirect connection through an intermediate medium. For those skilled in the art, the specific meanings of the above terms in the present application may be understood according to specific situations.

In the description of this specification, descriptions referring to the terms, such as "embodiment", "an embodiment", "some examples", "exemplarily" and "an implementation", mean that specific features, structures, materials or characteristics described in conjunction with the embodiment or the implementation are included in at least one embodiment or implementation of the present application. In this specification, schematic expressions of the above terms do not necessarily refer to the same embodiment or implementation. Furthermore, the specific features, structures, materials or characteristics described may be combined in any suitable manner in any one or more embodiments or implementations.

The terms such as "first", "second" and the like are merely for description, and should not be construed as indicating or implying relative importance, or implicitly indicating the number of the indicated technical features. In this way, the feature defined by the term "first" or "second" may explicitly or implicitly include at least one such feature.

In the drawings, the Z-axis denotes a vertical direction, i.e. an up-down direction, where a positive direction (i.e. a direction indicated by an arrow of the Z-axis) of the Z-axis indicates an upper side, and a negative direction of the Z-axis indicates a lower side. The X-axis denotes a front-rear direction, where a positive direction (i.e. a direction indicated by an arrow of the X-axis) of the X-axis indicates a front side, and a negative direction of the X-axis indicates a rear side. The Y-axis denotes a horizontal direction, which is designated as a left-right direction, where a positive direction (i.e. a direction indicated by an arrow of the Y-axis) of the Y-axis indicates a right side, and a negative direction of the Y-axis indicates a left side. It should also be noted that, the meanings of the Z-axis, Y-axis and X-axis described hereinabove are merely for the convenience of describing the present application and simplifying the description, and do not indicate or imply that the device or element referred to must have a particular orientation, or be configured and operated in a particular orientation, which therefore should not be construed as a limitation to the scope of the present application.

At present, in some electronic devices, such as an inverter, some structures are generally arranged outside a housing structure of the electronic device for a good heat dissipation performance. For example, an inductor assembly that generates a huge amount of heat or a radiator assembly for heat dissipation is arranged outside the housing structure. These external structures usually pass through a through hole on the housing structure and are connected to a component inside the housing structure, thereby ensuring the heat dissipation performance of the entire device.

These external structures and the housing structure may not be tightly connected at the through hole due to reasons such as manufacturing and mounting errors, which leads to a risk of leakage, and therefore the sealing requirement of the electronic device is difficult to meet.

In the conventional technologies, an elastic sealing ring is provided at a joint surface between the external structure and the housing structure, and the sealing at the joint surface between the external structure and the housing structure can be achieved by the elastic sealing ring. In this way, material types and assembling costs are increased. Furthermore, the elastic sealing ring is easy to rebound, thereby affecting the consistency of relative position of the external structure and the component inside the housing structure, and further affecting the connection reliability between the external structure and the component inside the housing structure. For example, the contact thermal conductivity between an internal component and a radiator assembly may be affected, thereby affecting the operation performance of the electronic device.

Some electronic devices may be filled with a sealant to improve the heat dissipation performance and waterproof performance. When the leakage is likely to occur between the external structure and the housing structure, the filled sealant may leak through the joint surface between the external structure and the housing structure, thereby affecting the package integrity of the sealant. As a result, the operation performance of the electronic device is affected, and an additional process is needed to process the leaked sealant, which affects the production efficiency of the electronic device.

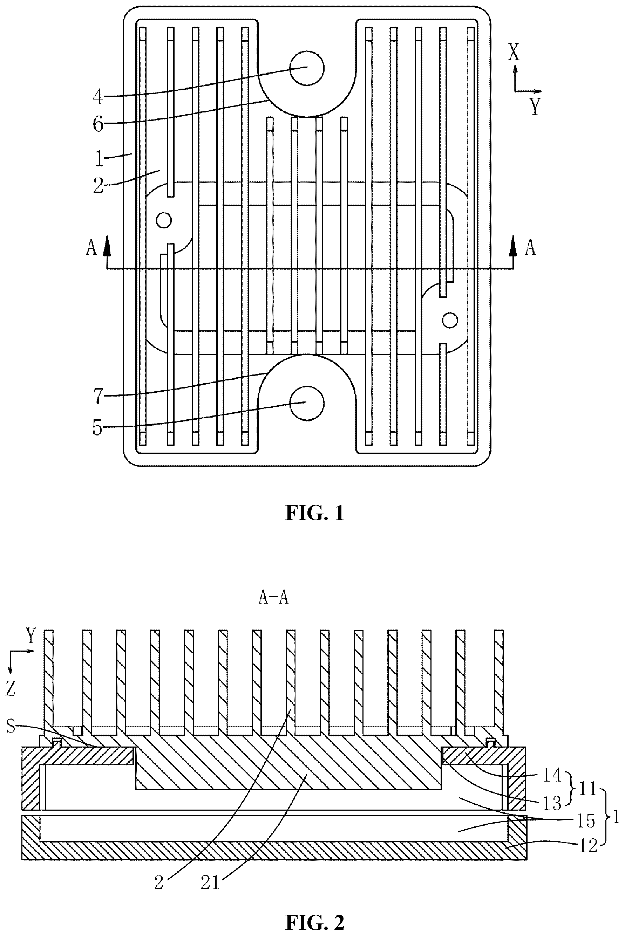

As shown in FIG. 1 to FIG. 4, in a first aspect, an electronic device is provided according to the present application, including a housing structure 1, a predetermined structure 2, and at least one insertion connection structure 3. The housing structure 1 is provided with a through hole 13, and the predetermined structure 2 is correspondingly arranged at the through hole 13 and is exposed outside the housing structure 1. The predetermined structure 2 is attached to a predetermined side of the housing structure 1 along a depth direction of the through hole 13 to form an attaching surface S surrounding the through hole 13, and the at least one insertion connection structure 3 is provided between the predetermined structure 2 and the housing structure 1 at the attaching surface S. The at least one insertion connection structure 3 includes a groove portion 31 and an insertion portion 32 provided on the predetermined structure 2 and the housing structure 1. The groove portion 31 is connected to the insertion portion 32 by insertion, and the groove portion 31 surrounds the through hole 13.

In the embodiment, the housing structure 1 includes a first housing 11 and a second housing 12, and the first housing 11 and the second housing 12 enclose to form a mounting cavity 15. A main part of the electronic device, such as a circuit board unit of an inverter, is mounted in the mounting cavity 15. One or more of the first housing 11 and the second housing 12 is provided with the through hole 13. In this specification, as an example for description of the present application hereinafter, a predetermined plate 14 of the first housing 11, such as a bottom plate, is provided with the through hole 13.

In the embodiment, the depth direction of the through hole 13 is in the vertical direction, and the predetermined side may be an outer side. That is to say, an outer surface of the housing structure 1, such as an outer surface of the predetermined plate 14, is attached to the predetermined structure 2 to form the attaching surface S.

In other embodiments, the predetermined side may be an inner side. That is to say, an inner surface of the housing structure 1, such as an inner surface of the predetermined plate 14, is attached to the predetermined structure 2 to form the attaching surface S (this solution is not shown in the drawings).

In a same insertion connection structure 3, the groove portion 31 may be provided on the housing structure 1, and correspondingly, the insertion portion 32 may be provided on the predetermined structure 2. In an example, a first groove portion 31A of a first insertion connection structure 3A described hereinafter is provided on the outer surface of the predetermined plate 14 of the first housing 11, and a first insertion portion 32A of the first insertion connection structure 3A is provided on the predetermined structure 2.

In the same insertion connection structure 3, the groove portion 31 may be provided on the predetermined structure 2. In an example, the insertion portion 32 may be provided on the housing structure 1. For example, a second groove portion 31B of a second insertion connection structure 3B described hereinafter is provided on the predetermined structure 2, and a second insertion portion 32B of the second insertion connection structure 3B is provided on the outer surface of the predetermined plate 14 of the first housing 11.

In this way, the housing structure 1 is provided with the through hole 13, and the predetermined structure 2 is correspondingly arranged at the through hole 13 and is exposed outside the housing structure 1. The predetermined structure 2 can be connected to an internal component in the mounting cavity 15 of the housing structure 1 through the through hole 13 to satisfy the corresponding connection requirement, and a part of the predetermined structure 2 exposed outside the housing structure 1 can exchange heat with an external environment to satisfy the heat dissipation requirement. Moreover, the predetermined structure 2 is attached to the predetermined side of the housing structure 1 along the depth direction of the through hole 13 to form the attaching surface S surrounding the through hole 13, and the insertion connection structure 3 is provided between the predetermined structure 2 and the housing structure 1 at the attaching surface S. The insertion connection structure 3 includes the groove portion 31 and the insertion portion 32 provided on the predetermined structure 2 and the housing structure 1. The groove portion 31 is connected to the insertion portion 32 by insertion, and the groove portion 31 surrounds the through hole 13. In this way, when the predetermined structure 2 is connected to the housing structure 1, the predetermined structure 2 and the housing structure 1 are connected to each other by the insertion between the groove portion 31 and the insertion portion 32, and the predetermined structure 2 and the housing structure 1 can form a relatively complete sealing surface at the attaching surface S in the circumferential direction of the through hole 13 (the sealing surface includes a part that is formed at the attaching surface S, and a part having an included angle with respect to the attaching surface S). Therefore, the sealing reliability of the connection between the predetermined structure 2 and the housing structure 1 can be ensured, and a leaking path of the leakage from the mounting cavity 15 of the housing structure 1 through the through hole 13 can be complicated, thereby reducing the possibility of the leakage. In particular, when a sealant is required to be filled into the mounting cavity 15 of the housing structure 1, the possibility of leakage of the sealant through the through hole 13 and the attaching surface S between the predetermined structure 2 and the housing structure 1 is reduced, which ensures that most of the sealant filled into the mounting cavity 15 can be used for sealing, such as for wrapping a circuit board unit in the mounting cavity 15, and a subsequent sealant removing operation due to leakage of the sealant can be avoided. In summary, according to the electronic device of the present application, both the heat dissipation requirement and the sealing reliability requirement of the electronic device can be satisfied, and the operation performance and the production efficiency of the electronic device can be ensured. The sealing between the housing structure 1 and the predetermined structure 2 of the electronic device can be well achieved even without a sealing ring.

In an embodiment, the groove portion 31 of the at least one insertion connection structure 3 is spaced apart from an edge of the through hole 13 in a direction perpendicular to the depth direction of the through hole 13.

In an embodiment, the second groove portion 31B of the second insertion connection structure 3B described hereinafter is spaced apart from the edge of the through hole 13 (the edge of the through hole 13 may be understood as an inner wall of the through hole 13), and correspondingly, the second insertion portion 32B connected to the second groove portion 31B by insertion is also spaced apart from the edge of the through hole 13.

In this way, the leaking path of the mounting cavity 15, such as the leaking path of the sealant in the mounting cavity 15 leaking through the through hole 13 and the attaching surface S, is relatively long, thereby further reducing the possibility of the leakage.

In an embodiment, the number of the insertion connection structures 3 is more than one, and the multiple insertion connection structures 3 are distributed along the direction perpendicular to the depth direction of the through hole 13.

In this way, with the multiple insertion connection structures 3, the leaking path of the leakage from the mounting cavity 15 through the through hole 13 and the attaching surface S is further complicated and extended, thereby further reducing the possibility of the leakage and improving the sealing performance of the electronic device.

In an embodiment, at least two groove portions 31 of different insertion connection structures 3 are respectively arranged on the predetermined structure 2 and the housing structure 1.

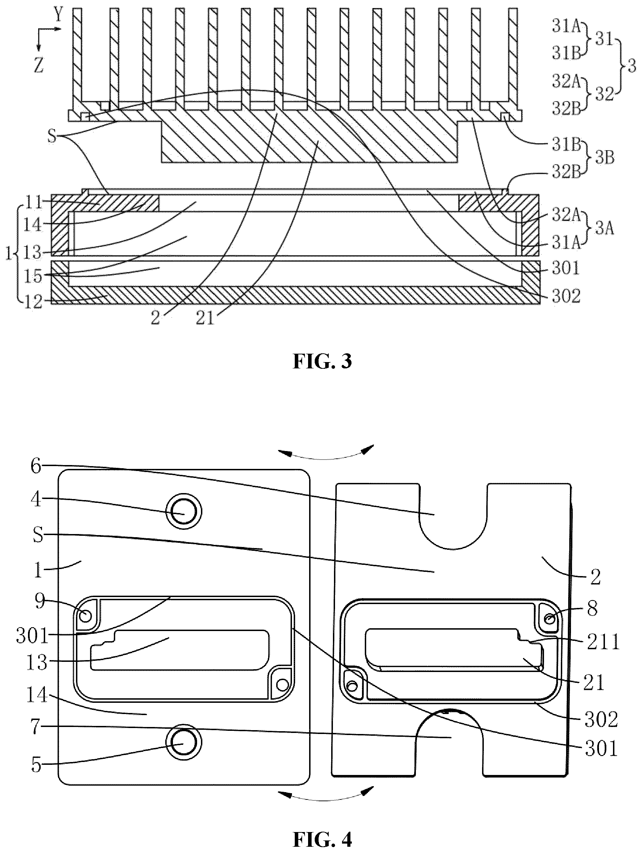

As shown in FIG. 3, in an example, the predetermined side is the outer side. A first annular protrusion 301 is formed on a top surface of the predetermined plate 14 and is spaced apart from the edge of the through hole 13, and a first annular groove 302 corresponding to the first annular protrusion 301 is formed on the predetermined structure 2. The first annular protrusion 301 and an area enclosed by the first annular protrusion 301 is configured to form the groove portion 31 of the first insertion connection structure 3A, i.e. the first groove portion 31A. An area enclosed by an inner circle of the first annular groove 302 on the predetermined structure 2 forms the insertion portion 32 of the first insertion connection structure 3A, i.e. the first insertion portion 32A. The first annular protrusion 301 is further configured to form the insertion portion 32 of the second insertion connection structure 3B, i.e. the second insertion portion 32B. The first annular groove 302 is further configured to form the groove portion 31 of the second insertion connection structure 3B, i.e. the second groove portion 31B.

In this way, the leakage path of the mounting cavity 15 is complicated, so as to reduce the possibility of the leakage. Furthermore, the first annular protrusion 301 can be used to form the first groove portion 31A and the second insertion portion 32B, which can reduce the complexity of the multiple insertion connection structures 3, so that the structure is simple and the practicability is high.

In the above embodiment, optionally, at least one of the predetermined structure 2 includes a radiator assembly 2A.

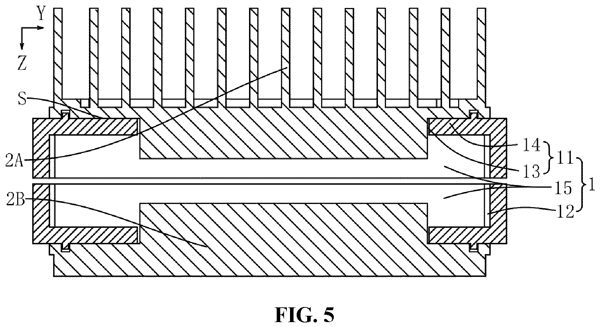

FIG. 1 and FIG. 4 show a case that the predetermined structure 2 is the radiator assembly 2A (labeled in FIG. 5). It should be understood that, the radiator assembly 2A may be configured as an integral structure or a split structure according to needs.

In this way, the radiator assembly 2A can be used to dissipate heat from the electronic device, while the sealing requirement is satisfied. Therefore, both the heat dissipation requirement and the sealing requirement of the electronic device can be satisfied.

In the above embodiment, optionally, at least one of the predetermined structure 2 includes a heat generating assembly 2B.

The heat generating assembly 2B is a component that produces heat during operation, such as an inductor assembly. The heat generating assembly 2B of the electronic device, such as the inductor assembly, is partially exposed outside the housing structure 1, so that the heat from the inductor assembly can be dissipated, and the sealing requirement is satisfied. Therefore, both the heat dissipation requirement and the sealing requirement of the electronic device can be satisfied.

It should be understood that, in some solutions, the number of the predetermined structures 2 may be more than one. At least one of the multiple predetermined structures 2 includes the radiator assembly 2A, and at least another one of the multiple predetermined structures 2 includes the heat generating assembly 2B.

In an example, the radiator assembly 2A and the heat generating assembly 2B are correspondingly mounted only on the first housing 11.

In an example, the radiator assembly 2A and the heat generating assembly 2B are correspondingly mounted only on the second housing 12.

As shown in FIG. 5, in an example, at least one predetermined structure 2, such as the radiator assembly 2A, is correspondingly mounted on the first housing 11, and at least one predetermined structure 2, such as the heat generating assembly 2B, is correspondingly mounted on the second housing 12.

As an example for description of the present application hereinafter, the radiator assembly 2Ais correspondingly mounted only on the first housing 11.

Further, the electronic device further includes a circuit board unit, and the circuit board unit is arranged in the mounting cavity 15 of the housing structure 1. The predetermined structure 2 passes through the through hole 13 and is connected to the circuit board unit.

In an embodiment, a part of the radiator assembly 2A located in the mounting cavity 15 of the housing structure 1 is attached to a circuit board or a power device of the circuit board unit, such as an insulated-gate bipolar transistor (IGBT). The radiator assembly 2A and the circuit board unit may be directly fixedly connected through a connector, or may be indirectly connected through a connecting structure, so that the radiator assembly 2A can dissipate heat from the circuit board unit.

The radiator assembly 2A may be a radiator having a good thermal conductivity and dissipation performance, such as a metal radiator, and the housing structure 1 is generally a plastic housing, which is not described in detail herein.

Referring to FIG. 2 to FIG. 4, when the predetermined structure 2 is attached to the predetermined side of the housing structure 1 along the depth direction of the through hole 13, a shape of a cross section (the cross section is a plane perpendicular to the Z-axis in the drawings) of a predetermined segment 21 of the predetermined structure 2 passing through the through hole 13 is the same as a shape of a cross section of the through hole 13.

In an embodiment, in a case that the attaching surface S is located on the outer side of the housing structure 1, the predetermined segment 21 is generally an inner segment of the radiator assembly 2A, and an end face of the predetermined segment 21 is attached to the circuit board unit.

In a case that the attaching surface S is located on the inner side of the housing structure 1, that is, in a case that the radiator assembly 2A passes through the through hole 13 from inside to outside, the predetermined segment 21 is generally a middle segment of the radiator assembly 2A. An inner end of the middle segment is further connected to an inner segment, and a cross-sectional area of the inner segment is larger than a cross-sectional area of the middle segment. The inner segment is attached to the predetermined plate 14 to form the attaching surface S (this solution is not shown in the drawings).

In this way, when the predetermined structure 2 is connected to the housing structure 1, the predetermined segment 21 abuts against the inner wall of the through hole 13 in any direction in the cross section of the predetermined segment 21, so as to limit relative movement of the predetermined structure 2 and the housing structure 1. In conjunction with the connection effect of the insertion connection structure 3, the stability of the relative position of the predetermined structure 2 and the housing structure 1 is relatively high.

Further, the predetermined segment 21 is provided with a foolproof portion 211, and the foolproof portion 211 makes the shape of the cross section of the predetermined segment 21 non-centrosymmetric.

As shown in FIG. 4, in an example, the overall shape of the cross section of the predetermined segment 21 is rectangular, and the foolproof portion 211 is a recess structure at a vertex of the rectangle. The rectangle with the recess structure is non-centrosymmetric.

In this way, the predetermined structure 2 can only pass through the through hole 13 in a preset posture, thereby ensuring the positioning reliability between the predetermined structure 2 and the housing structure 1.

As shown in FIG. 1 and FIG. 4, in an embodiment, the housing structure 1 is provided with a filling port 4 and an air discharging port 5.

Positions of the filling port 4 and the air discharging port 5 are not limited, as long as the filling of the sealant and the discharging of the air during sealant filling can be realized.

Further, in a case that the filling port 4 is located in an area corresponding to the attaching surface S, the predetermined structure 2 is provided with a first avoidance opening 6 corresponding to the filling port 4, so as to prevent the filling port 4 from being blocked.

Further, in a case that the air discharging port 5 is located in the area corresponding to the attaching surface S, the predetermined structure 2 is provided with a second avoidance opening 7 corresponding to the air discharging port 5, so as to prevent the air discharging port 5 from being blocked.

In an embodiment, the predetermined structure 2 and the housing structure 1 are connected to each other by at least one of a snap-fit connection and a connection by a fastener.

The fastener may be a threaded connector, and the threaded connector passes through one of the predetermined structure 2 and the housing structure 1 and is threadedly connected to the other one of the predetermined structure 2 and the housing structure 1. For example, referring to FIG. 4, the threaded connector passes through a first connecting hole 8 and is threadedly connected to a second connecting hole 9.

In a second aspect, an electrical power system is provided according to the present application, including the electronic device described above. The electronic device may be a power electronic device, such as an inverter.

The electrical power system has all the beneficial effects of the electronic device, which is not described in detail herein.

Although the present application is disclosed hereinabove, the protection scope of the present application is not limited thereto. Many variations and modifications may be made by those skilled in the art without departing from the spirit and scope of the present application, and these variations and modifications are deemed to fall into the protection scope of the present application.

## Claims

1. An electronic device, comprising a housing structure (1), a predetermined structure (2), and at least one insertion connection structure (3), wherein
the housing structure (1) is provided with a through hole (13), and the predetermined structure (2) is correspondingly arranged at the through hole (13) and is exposed outside the housing structure (1);
the predetermined structure (2) is attached to a predetermined side of the housing structure (1) along a depth direction of the through hole (13) to form an attaching surface (S) surrounding the through hole (13), and the at least one insertion connection structure (3) is provided between the predetermined structure (2) and the housing structure (1) at the attaching surface (S); and
the at least one insertion connection structure (3) comprises a groove portion (31) and an insertion portion (32) that are provided on the predetermined structure (2) and the housing structure (1), the groove portion (31) is connected to the insertion portion (32) by insertion, and the groove portion (31) surrounds the through hole (13).

2. The electronic device according to claim 1, wherein the groove portion (31) of the at least one insertion connection structure (3) is spaced apart from an edge of the through hole (13) in a direction perpendicular to the depth direction of the through hole (13).

3. The electronic device according to claim 1, wherein the number of the insertion connection structures (3) is more than one, and the insertion connection structures (3) are distributed in a direction perpendicular to the depth direction of the through hole (13).

4. The electronic device according to claim 3, wherein at least two groove portions (31) of different insertion connection structures (3) are respectively arranged on the predetermined structure (2) and the housing structure (1).

5. The electronic device according to claim 1, further comprising a circuit board unit, wherein the circuit board unit is arranged in a mounting cavity (15) of the housing structure (1), and the predetermined structure (2) passes through the through hole (13) and is connected to the circuit board unit.

6. The electronic device according to any one of claims 1 to 5, wherein at least one predetermined structure (2) comprises a radiator assembly (2A), and/or, at least one predetermined structure (2) comprises a heat generating assembly (2B).

7. The electronic device according to any one of claims 1 to 5, wherein when the predetermined structure (2) is attached to the predetermined side of the housing structure (1) along the depth direction of the through hole (13), a shape of a cross section of a predetermined segment (21) of the predetermined structure (2) passing through the through hole (13) is the same as a shape of a cross section of the through hole (13).

8. The electronic device according to claim 7, wherein the predetermined segment (21) is provided with a foolproof portion (211), which makes the shape of the cross section of the predetermined segment (21) be non-centrosymmetric.

9. The electronic device according to any one of claims 1 to 5, wherein
the housing structure (1) is provided with a filling port (4) and an air discharging port (5);
in a case that the filling port (4) is located in an area corresponding to the attaching surface (S), the predetermined structure (2) is provided with a first avoidance opening (6) corresponding to the filling port (4); and in a case that the air discharging port (5) is located in the area corresponding to the attaching surface (S), the predetermined structure (2) is provided with a second avoidance opening (7) corresponding to the air discharging port (5); and/or
the predetermined structure (2) and the housing structure (1) are connected to each other by at least one of a snap-fit connection and a connection by a fastener; and/or
the electronic device is an inverter.

10. An electrical power system, comprising the electronic device according to any one of claims 1 to 9.
